# EUROPEAN PATENT APPLICATION

(11) **EP 3 882 987 A1**
(43) Date of publication of application: **22.09.2021**
(21) Application number: 20195261.1
(22) Date of filing: 09.09.2020
(51) Int. Cl.: H01L 31/107, H01L 31/0224, H01L 31/0352, H01L 27/144

(54) **LIGHT DETECTOR, LIGHT DETECTION SYSTEM, LIDAR DEVICE, AND VEHICLE**

(30) Priority: 19.03.2020 JP 2020049455
(71) Applicant: KABUSHIKI KAISHA TOSHIBA, Minato-ku Tokyo 105-0023 (JP)
(72) Inventor: Fujiwara, Ikuo, Tokyo, 105-0023 (JP); Kwon, Honam, Tokyo, 105-0023 (JP); Sasaki, Keita, Tokyo, 105-0023 (JP); Suzuki, Kazuhiro, Tokyo, 105-0023 (JP); Atsuta, Masaki, Tokyo, 105-0023 (JP); Shimizu, Mariko, Tokyo, 105-0023 (JP); Okamoto, Kazuaki, Tokyo, 105-0023 (JP)
(74) Representative: Hoffmann Eitle

(57) **Abstract**

According to one embodiment, a light detector (100) includes a first semiconductor region of a first conductivity type, a first element (11), a second element (12), an insulating body (30), a first interconnect (61), and a second interconnect (62). The second semiconductor region (2) of the first element (11) is provided on the first semiconductor region (1). The third semiconductor region (3) of the first element (11) is provided on the second semiconductor region (2), and contacts the second semiconductor region (2). The fourth semiconductor region (4) of the second element (12) is provided on the first semiconductor region (1), and has an impurity concentration of a first conductivity type less than in the second semiconductor region (2). The fifth semiconductor region (5) of the second element (12) is provided on the fourth semiconductor region (4), and contacts the fourth semiconductor region (4). The insulating body (30) is provided between the first element (11) and the second element (12). The first interconnect (61) is electrically connected to the third semiconductor region (3). The second interconnect (62) is electrically connected to the fifth semiconductor region (5).

## Description

### FIELD

Embodiments described herein relate generally to a light detector, a light detection system, a lidar device, and a vehicle.

### BACKGROUND

A light detector detects light incident on an element including a semiconductor region of a first conductivity type and a semiconductor region of a second conductivity type. It is desirable to reduce the dead time of the light detector.

### BRIEF DESCRIPTION OF THE DRAWINGS

FIG. 1 is a schematic plan view illustrating a light detector according to a first embodiment;
FIG. 2 is an enlarged plan view of portion II of FIG. 1;
FIG. 3 is a III-III cross-sectional view of FIG. 2;
FIG. 4 is a IV-IV cross-sectional view of FIG. 2;
FIGS. 5A and 5B are schematic views illustrating manufacturing processes of the light detector according to the first embodiment;
FIGS. 6A and 6B are schematic views illustrating manufacturing processes of the light detector according to the first embodiment;
FIGS. 7A and 7B are schematic views illustrating manufacturing processes of the light detector according to the first embodiment;
FIGS. 8A and 8B are schematic views illustrating manufacturing processes of the light detector according to the first embodiment;
FIGS. 9A and 9B are schematic views illustrating manufacturing processes of the light detector according to the first embodiment;
FIGS. 10A and 10B are schematic views illustrating manufacturing processes of the light detector according to the first embodiment;
FIGS. 11A and 11B are schematic views illustrating manufacturing processes of the light detector according to the first embodiment;
FIGS. 12A and 12B are schematic views illustrating manufacturing processes of the light detector according to the first embodiment;
FIGS. 13A and 13B are schematic views illustrating manufacturing processes of the light detector according to the first embodiment;
FIGS. 14A and 14B are schematic views illustrating manufacturing processes of the light detector according to the first embodiment;
FIGS. 15A and 15B are schematic views illustrating manufacturing processes of the light detector according to the first embodiment;
FIGS. 16A and 16B are schematic views illustrating manufacturing processes of the light detector according to the first embodiment;
FIG. 17 is a schematic view illustrating manufacturing processes of the light detector according to the first embodiment;
FIG. 18 is a schematic cross-sectional view showing a portion of the light detector according to the first embodiment;
FIG. 19 is a schematic plan view illustrating a portion of the light detector according to the first embodiment;
FIG. 20 is a schematic plan view illustrating a portion of the light detector according to the first embodiment;
FIG. 21 is a schematic plan view illustrating a portion of a light detector according to a reference example;
FIG. 22 is a schematic plan view illustrating a light detector according to a second embodiment;
FIG. 23 is an enlarged plan view of portion XXIII of FIG. 22;
FIG. 24 is a XXIV-XXIV cross-sectional view of FIG. 23;
FIG. 25 is a schematic cross-sectional view showing a portion of the light detector according to the second embodiment;
FIG. 26 is a schematic view illustrating a lidar (Laser Imaging Detection and Ranging (LIDAR)) device according to a third embodiment;
FIG. 27 is a drawing for describing the detection of the detection object of the lidar device; and
FIG. 28 is a schematic top view of a vehicle including the lidar device according to the third embodiment.

### DETAILED DESCRIPTION

According to one embodiment, a first semiconductor region of a first conductivity type, a light detector includes a first element, a second element, an insulating body, a first interconnect, and a second interconnect. The first element includes a second semiconductor region of the first conductivity type, and a third semiconductor region of a second conductivity type. The second semiconductor region is provided on the first semiconductor region. The third semiconductor region is provided on the second semiconductor region, and contacts the second semiconductor region. The second element is arranged with the first element in a direction perpendicular to a first direction. The first direction is from the first semiconductor region toward the first element. The second element includes a fourth semiconductor region of the first conductivity type and a fifth semiconductor region of the second conductivity type. The fourth semiconductor region is provided on the first semiconductor region. An impurity concentration of the first conductivity type in the fourth semiconductor region is less than an impurity concentration of the first conductivity type in the second semiconductor region. The fifth semiconductor region is provided on the fourth semiconductor region, and contacts the fourth semiconductor region. The insulating body is provided between the first element and the second element. The first interconnect is electrically connected to the third semiconductor region. The second interconnect is electrically connected to the fifth semiconductor region.

Various embodiments are described below with reference to the accompanying drawings.

The drawings are schematic and conceptual; and the relationships between the thickness and width of portions, the proportions of sizes among portions, etc., are not necessarily the same as the actual values. The dimensions and proportions may be illustrated differently among drawings, even for identical portions.

In the specification and drawings, components similar to those described previously in an antecedent drawing are marked with like reference numerals, and a detailed description is omitted as appropriate.

In the embodiments described below, each embodiment may be implemented by inverting the p-type and the n-type of each semiconductor region.

### First embodiment

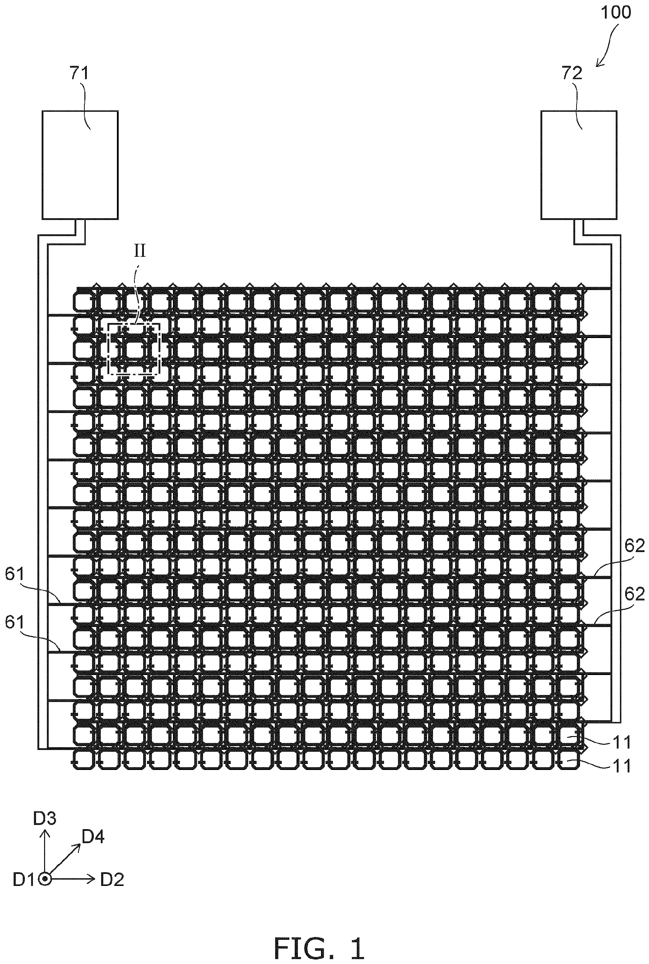

FIG. 1 is a schematic plan view illustrating a light detector according to a first embodiment.

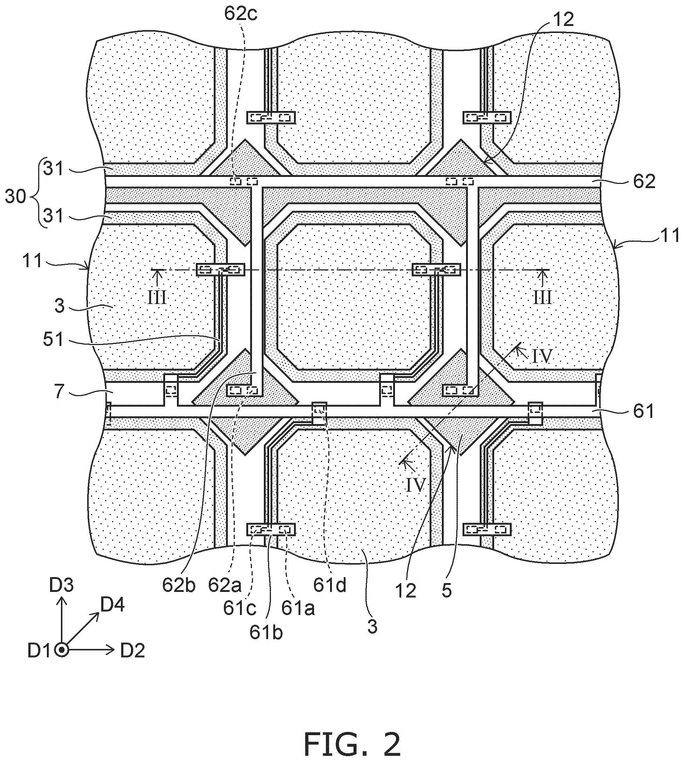

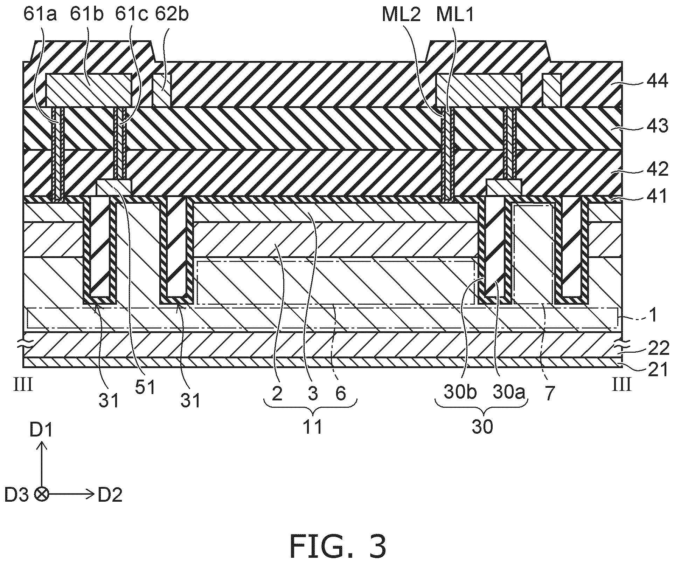

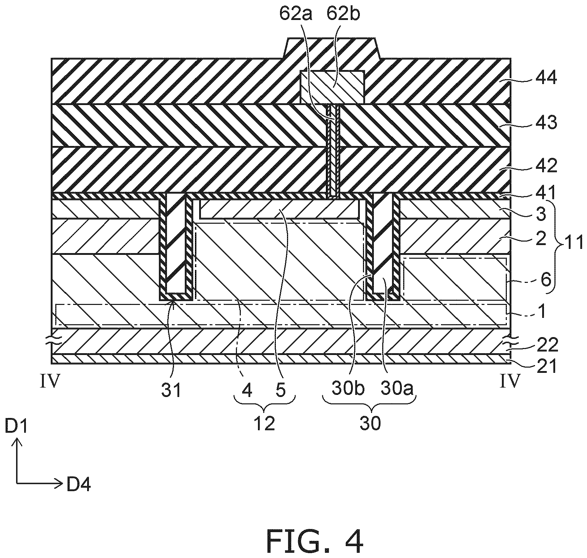

FIG. 2 is an enlarged plan view of portion II of FIG. 1. FIG. 3 is a III-III cross-sectional view of FIG. 2. FIG. 4 is a IV-IV cross-sectional view of FIG. 2.

As shown in FIGS. 1 to 4, the light detector 100 according to the first embodiment includes a first semiconductor region 1 of a first conductivity type, a first element 11, a second element 12, an electrode 21, a conductive layer 22, an insulating body 30, insulating layers 41 to 44, a first quenching part 51, a first interconnect 61, a second interconnect 62, a first pad 71, and a second pad 72.

Here, a direction from the first semiconductor region 1 toward the first element 11 is taken as a first direction D1. Two mutually-orthogonal directions perpendicular to the first direction D1 are taken as a second direction D2 and a third direction D3. A direction that is perpendicular to the first direction D1 and oblique to the second and third directions D2 and D3 is taken as a fourth direction D4. In the description, the direction from the first semiconductor region 1 toward the first element 11 is called "up", and the reverse direction is called "down". These directions are based on the relative positional relationship between the first semiconductor region 1 and the first element 11 and are independent of the direction of gravity.

As shown in FIG. 3, the conductive layer 22 is provided on the electrode 21. The first semiconductor region 1 is provided on the conductive layer 22. The first element 11, the second element 12, and the insulating body 30 are provided on the first semiconductor region 1.

The first element 11 includes a second semiconductor region 2 of the first conductivity type and a third semiconductor region 3 of a second conductivity type. The first conductivity type is one of a p-type or an n-type. The second conductivity type is the other of the p-type or the n-type. In the description hereinbelow, the first conductivity type is the p-type, and the second conductivity type is the n-type.

The third semiconductor region 3 is provided on the second semiconductor region 2 and contacts the second semiconductor region 2. A p-n junction is formed between the second semiconductor region 2 and the third semiconductor region 3. For example, the p-n junction surface is parallel to the second and third directions D2 and D3.

The first element 11 may further include a semiconductor region 6. The second semiconductor region 2 and the third semiconductor region 3 are provided on the semiconductor region 6. The second semiconductor region 2 is electrically connected to the electrode 21 via the semiconductor region 6, the first semiconductor region 1, and the conductive layer 22.

As shown in FIG. 4, the second element 12 includes a fourth semiconductor region 4 of the first conductivity type and a fifth semiconductor region 5 of the second conductivity type. The fifth semiconductor region 5 is provided on the fourth semiconductor region 4 and contacts the fourth semiconductor region 4. A p-n junction is formed between the fourth semiconductor region 4 and the fifth semiconductor region 5. For example, the p-n junction surface is parallel to the second and third directions D2 and D3. The fourth semiconductor region 4 is electrically connected to the electrode 21 via the first semiconductor region 1 and the conductive layer 22.

The impurity concentration of the first conductivity type in the fourth semiconductor region 4 is less than the impurity concentration of the first conductivity type in the second semiconductor region 2. For example, the thickness in the first direction D1 of the second semiconductor region 2 is less than the thickness in the first direction D1 of the fourth semiconductor region 4. For example, the thickness in the first direction D1 of the fourth semiconductor region 4 is equal to the sum of the thickness in the first direction D1 of the second semiconductor region 2 and the thickness in the first direction D1 of the semiconductor region 6.

Voltages are applied between the second semiconductor region 2 and the third semiconductor region 3 and between the fourth semiconductor region 4 and the fifth semiconductor region 5 by controlling the potential of the electrode 21. For example, the first element 11 and the second element 12 function as avalanche photodiodes.

As shown in FIG. 2, multiple first elements 11 are provided in the second and third directions D2 and D3. The second element 12 is provided between the first elements 11 adjacent to each other in the fourth direction D4. The fifth semiconductor region 5 of the second element 12 may extend toward and be connected to the fifth semiconductor region 5 of another second element 12 adjacent in the second direction D2.

For example, when viewed along the first direction D1, the shape of the p-n junction surface between the second semiconductor region 2 and the third semiconductor region 3 is different from the shape of the p-n junction surface between the fourth semiconductor region 4 and the fifth semiconductor region 5. When viewed along the first direction D1, the surface area of the p-n junction surface between the second semiconductor region 2 and the third semiconductor region 3 is greater than the surface area of the p-n junction surface between the fourth semiconductor region 4 and the fifth semiconductor region 5.

A portion of the first semiconductor region 1 is positioned under the first element 11 and the second element 12. Another portion of the first semiconductor region 1 is positioned under the insulating body 30. The p-type impurity concentration in the portion of the first semiconductor region 1 may be different from the p-type impurity concentration in the other portion of the first semiconductor region 1. For example, the p-type impurity concentration in the other portion of the first semiconductor region 1 may be greater than the p-type impurity concentration in the portion of the first semiconductor region 1.

The insulating body 30 is provided between the first elements 11 and between the first element 11 and the second element 12. For example, as shown in FIG. 2, the insulating body 30 includes multiple first insulating portions 31. The multiple first insulating portions 31 are provided respectively around the multiple first elements 11 along a first plane perpendicular to the first direction D1. The multiple first insulating portions 31 are separated from each other.

The second semiconductor region 2 and the third semiconductor region 3 may contact the first insulating portion 31 or may be separated from the first insulating portion 31. When the second semiconductor region 2 and the third semiconductor region 3 are separated from the first insulating portion 31, a portion of the semiconductor region 6 is provided between the second semiconductor region 2 and the first insulating portion 31 and between the third semiconductor region 3 and the first insulating portion 31.

The fifth semiconductor region 5 may contact the first insulating portion 31 or may be separated from the first insulating portion 31. When the fifth semiconductor region 5 is separated from the first insulating portion 31, a portion of the fourth semiconductor region 4 is provided between the fifth semiconductor region 5 and the first insulating portion 31.

As shown in FIG. 3, a semiconductor region 7 of the first conductivity type may be provided between the adjacent first insulating portions 31. As shown in FIG. 2, the semiconductor region 7 is arranged with the second element 12 in the second direction D2 or the third direction D3.

The insulating layer 41 is provided on the first element 11, the second element 12, and the insulating body 30. The insulating layer 42 is provided on the insulating layer 41. The insulating layer 43 is provided on the insulating layer 42. The insulating layer 44 is provided on the insulating layer 43.

As shown in FIG. 2, the third semiconductor region 3 is electrically connected to the first interconnect 61. For example, the third semiconductor region 3 is electrically connected to the first interconnect 61 via a plug 61a, an interconnect 61b, a plug 61c, the first quenching part 51, and a plug 61d.

The fifth semiconductor region 5 is electrically connected to the second interconnect 62. For example, a portion of the multiple fifth semiconductor regions 5 is electrically connected to the second interconnect 62 via a plug 62a and an interconnect 62b. Another portion of the multiple fifth semiconductor regions 5 is electrically connected to the second interconnect 62 via a plug 62c.

The electrical resistance of the first quenching part 51 is greater than the electrical resistances of the plug 61a, the interconnect 61b, the plug 61c, and the plug 61d. It is favorable for the electrical resistance of the first quenching part 51 to be not less than 50 kΩ and not more than 2 MΩ.

For example, at least a portion of the first quenching part 51 is provided on the semiconductor region 7 or the insulating body 30. The first quenching part 51 is not provided on the first element 11. Shielding by the first quenching part 51 of the light traveling toward the first element 11 can be suppressed thereby.

The first quenching part 51 is provided to suppress the continuation of the avalanche breakdown that has occurred due to light entering the first element 11. A voltage drop that corresponds to the electrical resistance of the first quenching part 51 occurs when avalanche breakdown occurs and a current flows in the first quenching part 51. The potential difference between the second semiconductor region 2 and the third semiconductor region 3 is reduced by the voltage drop, and the avalanche breakdown stops. The next light that is incident on the first element 11 can be detected thereby.

For example, the first element 11 operates in a Geiger mode in which a reverse voltage that is greater than the breakdown voltage is applied between the second semiconductor region 2 and the third semiconductor region 3 and between the fourth semiconductor region 4 and the fifth semiconductor region 5. By operating in the Geiger mode, a pulse signal that has a high gain and a short time constant is output.

As described above, a resistor that generates a large voltage drop may be provided as the first quenching part 51; conversely, instead of a resistor, a control circuit that blocks the current may be provided as the first quenching part 51. For example, the control circuit includes a comparator, a control logic part, and two switching elements. A known configuration called an active quenching circuit is applicable to the control circuit.

The first interconnect 61 and the second interconnect 62 extend along the second direction D2. For example, as shown in FIG. 1, the multiple first interconnects 61 and the multiple second interconnects 62 are alternately provided in the third direction D3. The multiple first interconnects 61 are electrically connected to the first pad 71. The multiple second interconnects 62 are electrically connected to the second pad 72. The second pad 72 is separated from the first pad 71.

The second interconnects 62 are separated from the first interconnects 61 and electrically isolated from the first interconnects 61. Therefore, the signal that is extracted from the first pad 71 can be different from the signal flowing through the second interconnects 62. The signal that is extracted from the second pad 72 can be different from the signal flowing through the first interconnects 61.

Examples of materials of the components will now be described.

The first semiconductor region 1, the second semiconductor region 2, the third semiconductor region 3, the fourth semiconductor region 4, the fifth semiconductor region 5, the semiconductor region 6, and the semiconductor region 7 include at least one semiconductor material selected from the group consisting of silicon, silicon carbide, gallium arsenide, and gallium nitride. Phosphorus, arsenic, or antimony may be used as the n-type impurity when these semiconductor regions include silicon. Boron or boron fluoride may be used as the p-type impurity.

The p-type impurity concentrations in the first semiconductor region 1, the fourth semiconductor region 4, the semiconductor region 6, and the semiconductor region 7 are, for example, not less than 1.0×10¹³ atoms/cm³ and not more than 1.0×10¹⁶ atoms/cm³. The p-type impurity concentration in the second semiconductor region 2 is, for example, not less than 1.0×10¹⁶ atoms/cm³ and not more than 1.0×10¹⁸ atoms/cm³. The n-type impurity concentrations in the third and fifth semiconductor regions 3 and 5 are, for example, not less than 1.0×10¹⁸ atoms/cm³ and not more than 1.0×10²¹ atoms/cm³.

The conductive layer 22 is, for example, a p-type semiconductor region. The conductive layer 22 includes a semiconductor material described above. The p-type impurity concentration in the conductive layer 22 is not less than 1.0×10¹⁷ atoms/cm³ and not more than 1.0×10²¹ atoms/cm³. Or, the conductive layer 22 may include a metal. For example, the conductive layer 22 includes at least one selected from the group consisting of aluminum, copper, titanium, gold, and nickel.

The insulating body 30 and the insulating layers 41 to 44 include insulating materials. For example, the insulating body 30 and the insulating layers 41 to 44 include silicon and one selected from the group consisting of oxygen and nitrogen. For example, the insulating body 30 and the insulating layers 41 to 44 include silicon oxide or silicon nitride. As shown in FIGS. 3 and 4, the insulating body 30 may include an insulating layer 30a and an insulating layer 30b. The insulating layer 30b is provided between the insulating layer 30a and the first semiconductor region 1, between the insulating layer 30a and the first element 11, between the insulating layer 30a and the second element 12, and between the insulating layer 30a and the semiconductor region 7. For example, the insulating layers 30a and 30b include silicon oxide; compared to the insulating layer 30a, the insulating layer 30b has a dense structure.

The first quenching part 51 that is used as the resistor includes polysilicon as a semiconductor material. An n-type impurity or a p-type impurity may be added to the first quenching part 51.

The plugs 61a, 61c, 61d, 62a, and 62c include metal materials. For example, the plugs 61a, 61c, 61d, 62a, and 62c include at least one selected from the group consisting of titanium, tungsten, copper, and aluminum. The plugs 61a, 61c, 61d, 62a, and 62c may include a conductor made of a silicon compound or a nitride of at least one selected from the group consisting of titanium, tungsten, copper, and aluminum. As shown in FIGS. 3 and 4, each plug may include metal layers ML1 and ML2. The metal layer ML2 is provided between the metal layer ML1 and the insulating layers. For example, the metal layer ML1 includes tungsten. The metal layer ML2 includes titanium. The metal layer ML2 may include a titanium layer, and a titanium nitride layer provided between the titanium layer and the metal layer ML1.

The electrode 21, the first interconnect 61, the interconnect 61b, the second interconnect 62, the interconnect 62b, the first pad 71, and the second pad 72 include at least one selected from the group consisting of copper and aluminum.

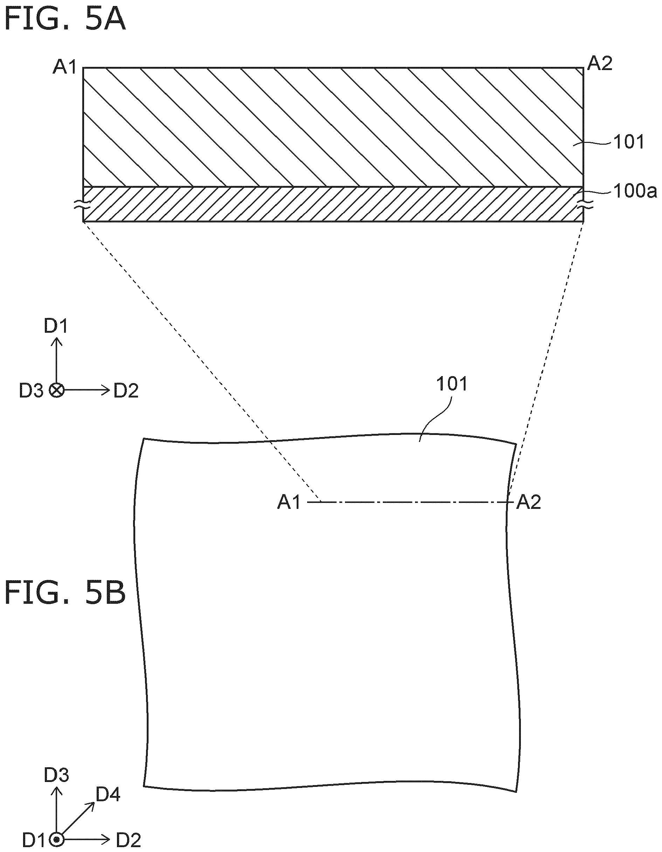

FIGS. 5A to 17 are schematic views illustrating manufacturing processes of the light detector according to the first embodiment.

FIGS. 5A to 16A respectively show A1-A2 cross sections of FIGS. 5B to 16B. An example of the manufacturing processes of the light detector according to the first embodiment will be described with reference to FIGS. 5A to 17.

As shown in FIGS. 5A and 5B, a substrate that includes a silicon substrate 100a and a p-type silicon epitaxial layer 101 is prepared. The direction from the silicon substrate 100a toward the silicon epitaxial layer 101 corresponds to the first direction D1. The silicon epitaxial layer 101 is formed by epitaxially growing silicon on the silicon substrate 100a. The silicon substrate 100a and the silicon epitaxial layer 101 include single-crystal p-type silicon doped with boron. The boron concentration in the silicon substrate 100a is 4.0×10¹⁸ cm⁻³. The boron concentration in the silicon epitaxial layer 101 is 1.0×10¹⁵ cm⁻³. The thickness of the silicon epitaxial layer 101 is 10 µm.

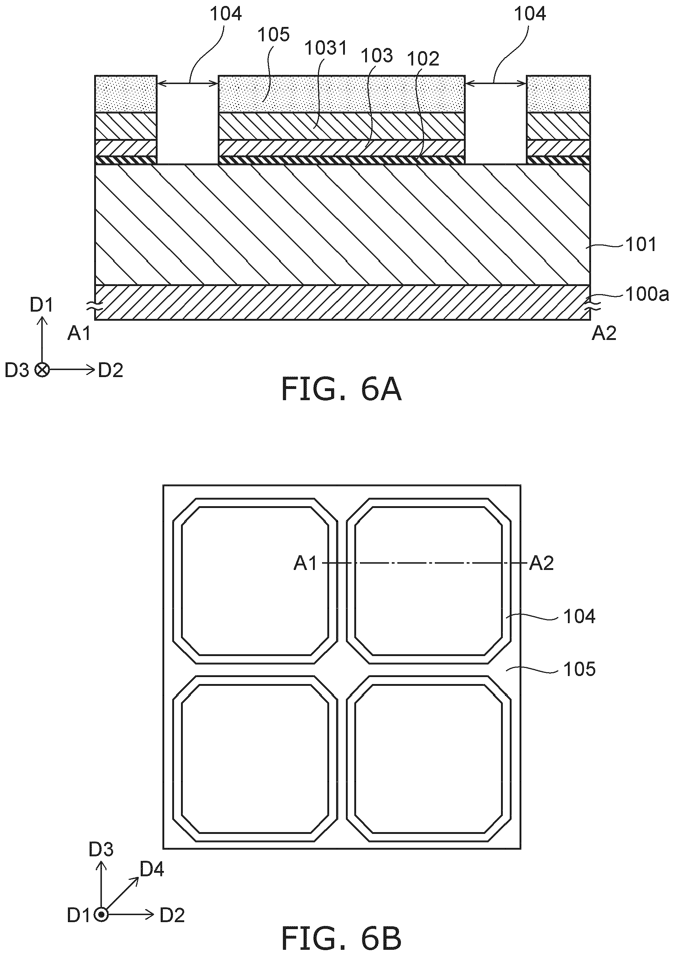

As shown in FIGS. 6A and 6B, a silicon oxide film 102 that has a thickness of 100 nm is formed by oxidizing the surface of the silicon epitaxial layer 101. A silicon nitride film 103 of 150 nm is deposited on the silicon oxide film 102 by low pressure thermal CVD. A silicon oxide film 1031 of 1 µm is deposited on the silicon nitride film 103 by low pressure thermal CVD. A resist 105 that defines an element separation region 104 is formed by a lithography process. The silicon oxide film 1031, the silicon nitride film 103, and the silicon oxide film 102 are etched via an opening of the resist 105 by reactive ion etching (RIE). The width of the element separation region 104 is 1.6 µm.

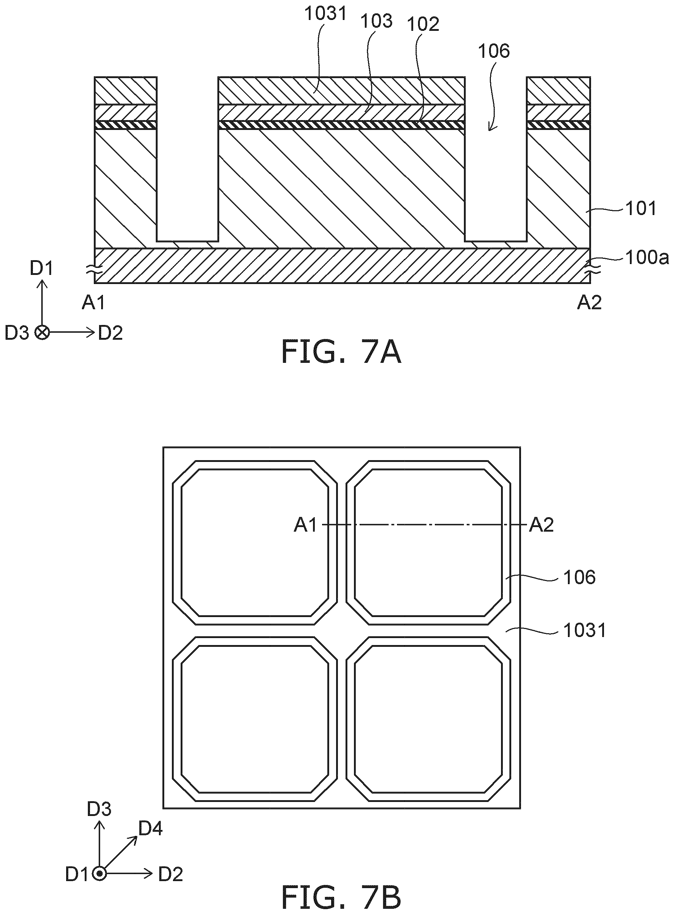

The resist 105 is stripped away as shown in FIGS. 7A and 7B. The silicon epitaxial layer 101 of the element separation region 104 is etched using the silicon oxide film 1031 as a mask. A first trench 106 is formed thereby. At this time, the depth of the etching is determined by the thickness of the silicon epitaxial layer 101 and the diffusion amount into the silicon epitaxial layer 101 of the boron included in the silicon substrate 100a. The diffusion amount is determined by considering the heating processes of the entire process. The etching depth is, for example, 8 µm. It is favorable to provide a taper angle of about 2° when forming the first trench 106. The taper angle is the tilt of the side surface of the first trench 106 with respect to the first direction D1. The occurrence of voids when subsequently filling with an oxide film can be suppressed thereby.

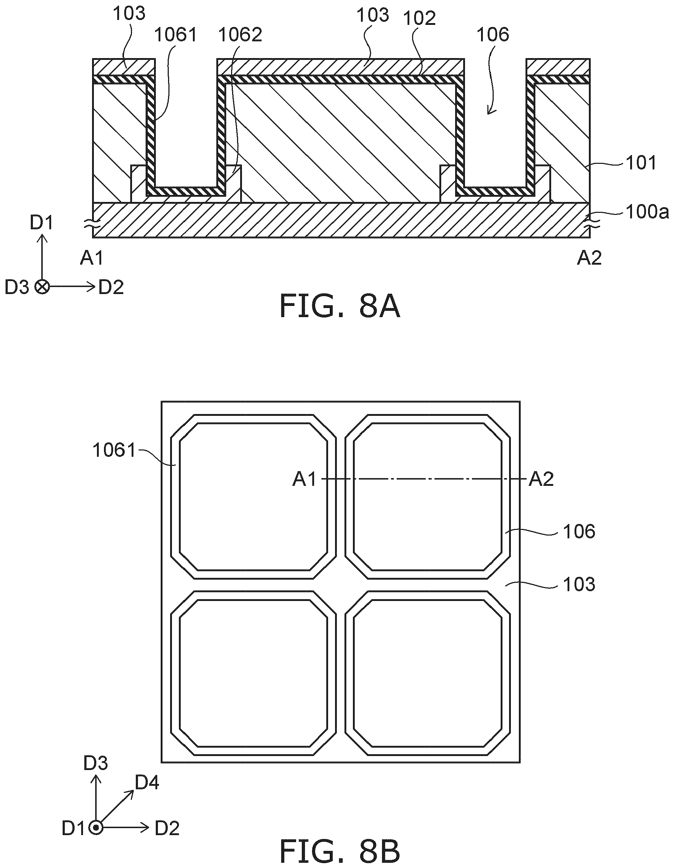

As shown in FIGS. 8A and 8B, a silicon oxide film 1061 that has a thickness of 50 nm is formed by oxidizing the surface of the first trench 106. An implantation region 1062 may be formed at the bottom portion of the first trench 106 by performing ion implantation into the entire substrate surface. The implantation region 1062 is formed by ion implantation of boron with an implantation acceleration voltage of 40 keV, an implantation dose of 2.5×10¹² cm⁻², and an angle from a substrate normal direction set to 0 degrees. If the angle is set to ±30 degrees at this time, the implantation region 1062 is formed also at the bottom portion side surface of the first trench 106 as shown in FIG. 8A. Crystal defects occur in the silicon epitaxial layer 101 when forming the first trench 106 by RIE. A noise component caused by the defects can be suppressed by forming the implantation region 1062 at the bottom portion side surface of the first trench 106.

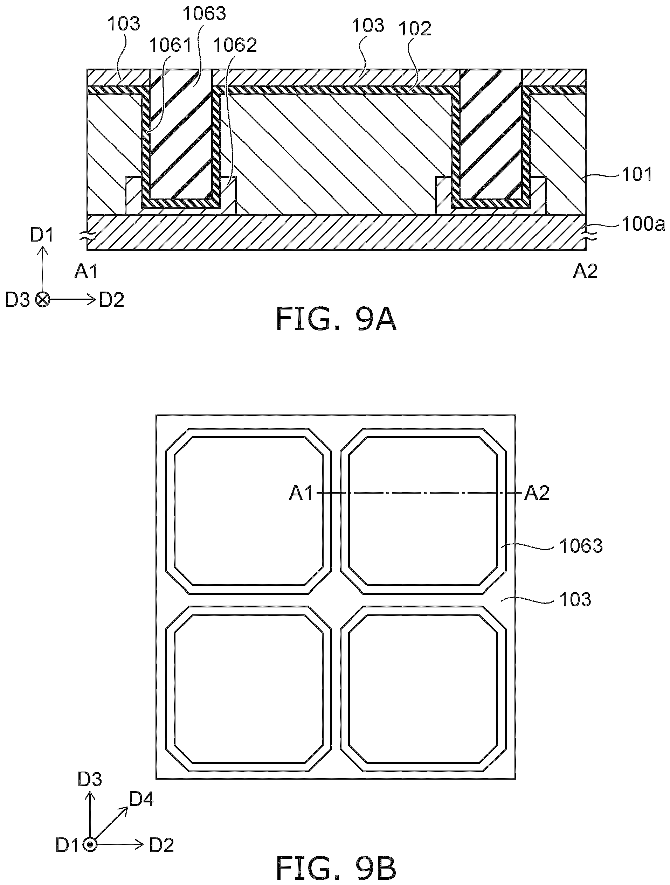

As shown in FIGS. 9A and 9B, a buried oxide film 1063 of 1.2 µm is deposited by plasma-enhanced chemical vapor deposition (CVD). The structure of the buried oxide film 1063 is densified by performing nitrogen annealing at 1000 °C. The buried oxide film 1063 is planarized by chemical mechanical polishing (CMP) processing using the silicon nitride film 103 as a stopper.

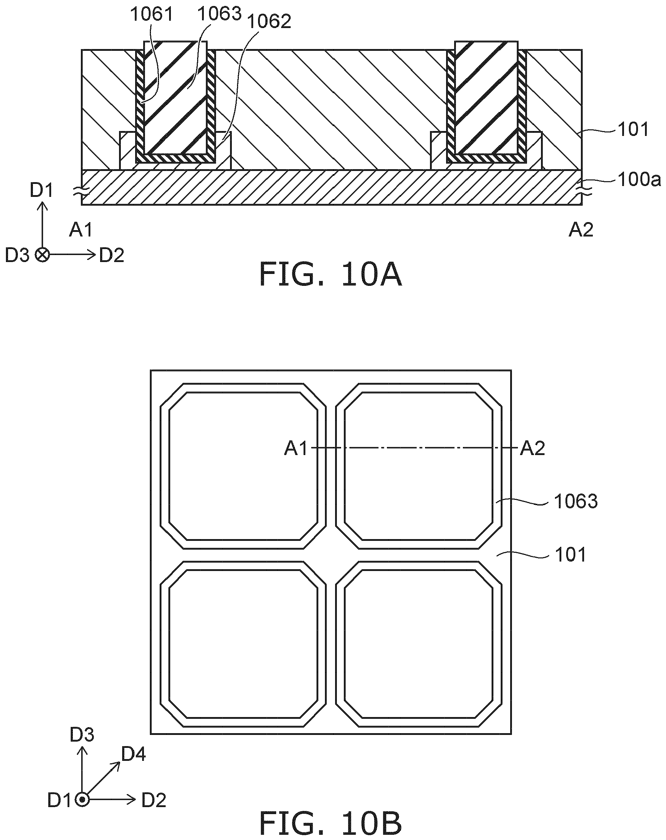

As shown in FIGS. 10A and 10B, the silicon nitride film 103 is stripped away by hot phosphoric acid treatment. The silicon oxide film 102 is stripped away by hydrofluoric acid treatment.

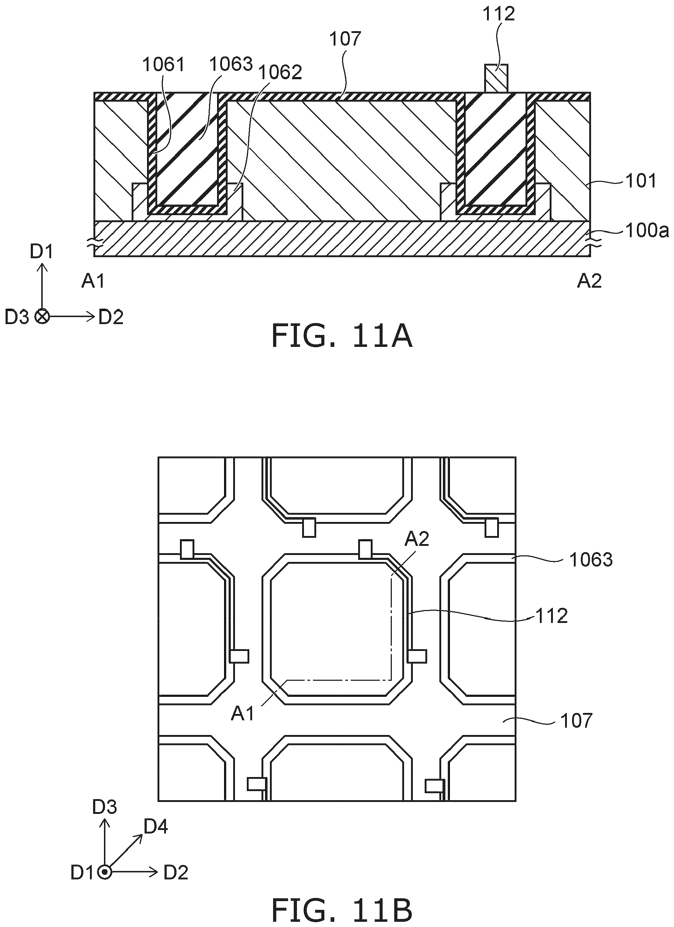

As shown in FIGS. 11A and 11B, a silicon oxide film 107 that has a thickness of 50 nm is formed by oxidizing the surface of the silicon epitaxial layer 101. A polysilicon film that has a thickness of 0.2 µm is formed by low pressure thermal CVD. A quenching resistance 112 is formed by patterning the silicon oxide film 107 and the polysilicon film into a prescribed shape by a lithography process and an RIE process. To adjust the resistance of the quenching resistance 112, for example, 1.0×10¹⁵ cm⁻² of an impurity is implanted by implanting boron with an implantation acceleration voltage of 20 keV and by performing an activation anneal.

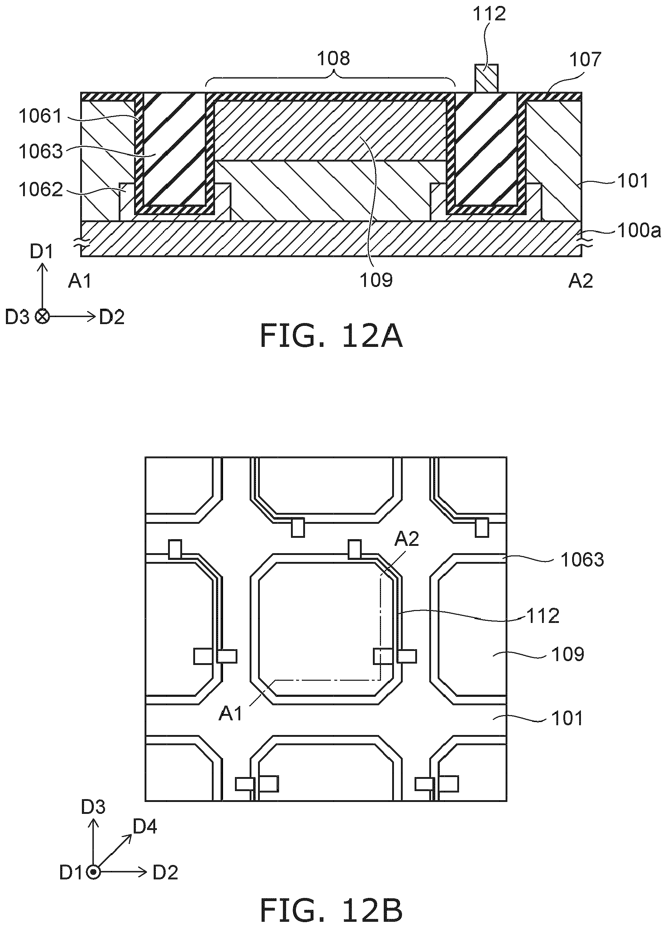

As shown in FIGS. 12A and 12B, a p-type avalanche layer 109 is formed and patterned in an element region 108 by a lithography process and an ion implantation process. The silicon oxide film 107 is not illustrated in FIGS. 12B to 17B. The p-type avalanche layer 109 is formed by ion implantation of boron. The p-type avalanche layer 109 is formed so that the boron has a peak depth of 0.8 µm and a peak concentration of 1.0×10¹⁷ cm⁻³.

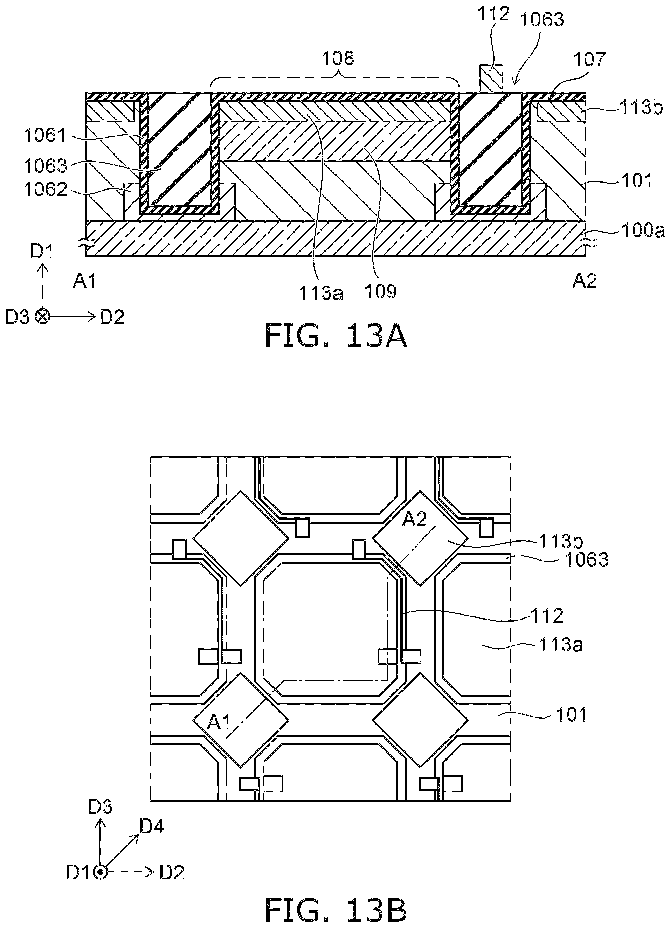

As shown in FIGS. 13A and 13B, n-type avalanche layers 113a and 113b are formed and patterned by a lithography process and an ion implantation process. The n-type avalanche layer 113a is formed in the element region 108. The n-type avalanche layer 113b is formed between the element regions 108 adjacent to each other in the fourth direction D4. The n-type avalanche layers 113a and 113b also are used as ohmic electrode portions between the semiconductor regions and the interconnects, which include metals. The n-type avalanche layers 113a and 113b are formed by ion implantation of phosphorus. The n-type avalanche layers 113a and 113b are formed so that the phosphorus has a peak positioned at the surface of the substrate and a peak concentration of 1.5×10²⁰ cm⁻³. Annealing is performed in a N₂ atmosphere to activate the n-type avalanche layers 113a and 113b.

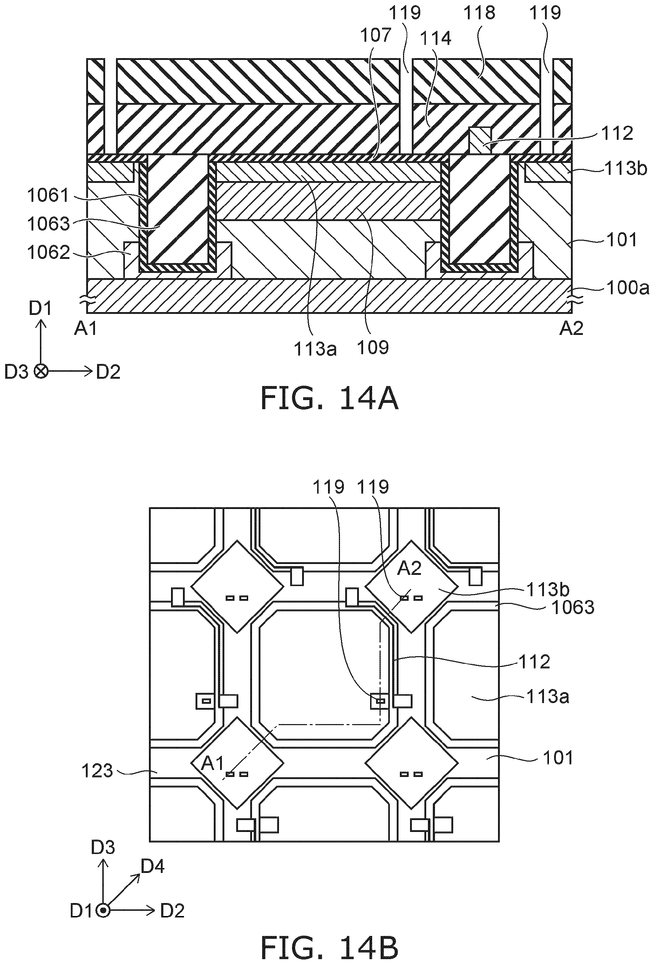

An insulating film 114 that has a thickness of 0.5 µm is formed by CVD. An insulating film 118 that has a thickness of 0.3 µm is formed by CVD. As shown in FIGS. 14A and 14B, multiple contact holes 119 that extend through the silicon oxide film 107, the insulating film 114, and the insulating film 118 are formed by a lithography process and an RIE process. The multiple contact holes 119 are formed respectively on the n-type avalanche layers 113a and 113b.

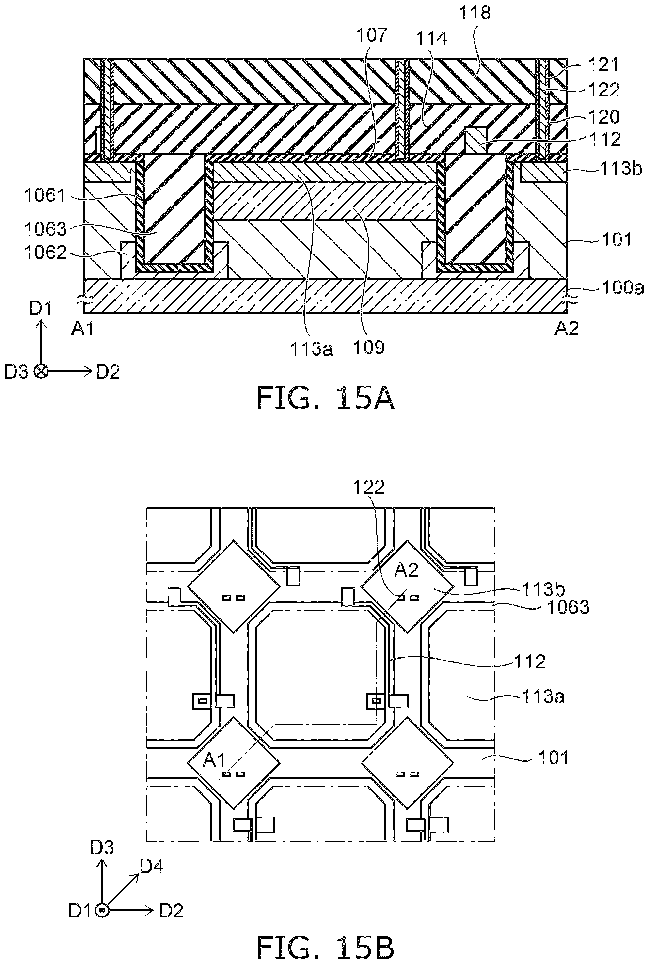

As shown in FIGS. 15A and 15B, a titanium film 120 of 10 nm and a titanium nitride film 121 of 10 nm are formed by sputtering. A tungsten film 122 of 0.3 µm is formed by CVD. The contact holes 119 are filled by planarizing the tungsten film 122, the titanium nitride film 121, and the titanium film 120 by CMP using the insulating film 118 as a stopper.

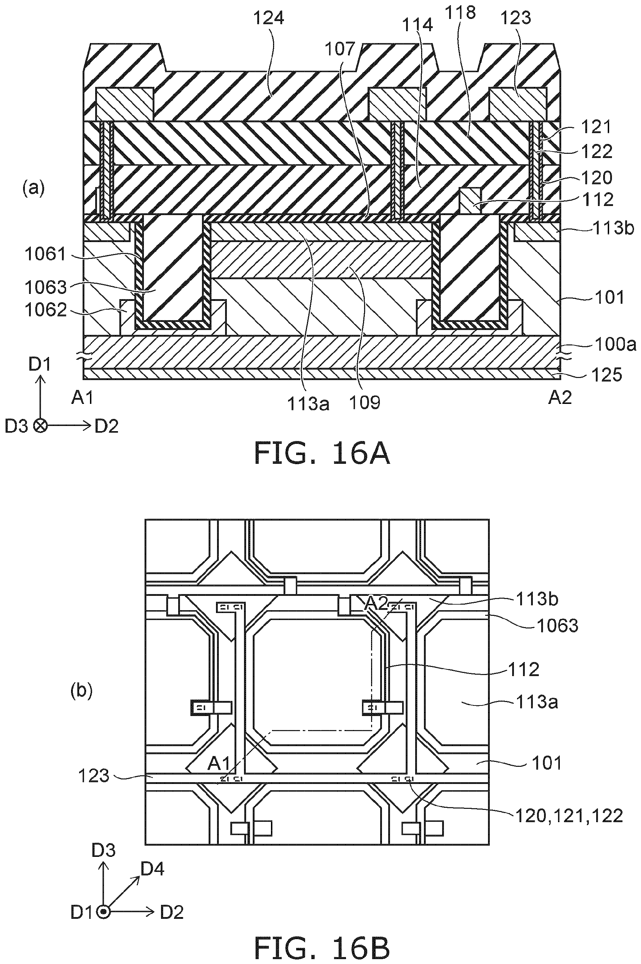

As shown in FIGS. 16A and 16B, an aluminum layer 123 that has a thickness of 0.5 µm is formed by sputtering. The aluminum layer 123 is patterned into a prescribed shape by a lithography process and an RIE process. A silicon nitride film that has a thickness of 0.3 µm is formed by CVD as a passivation film 124.

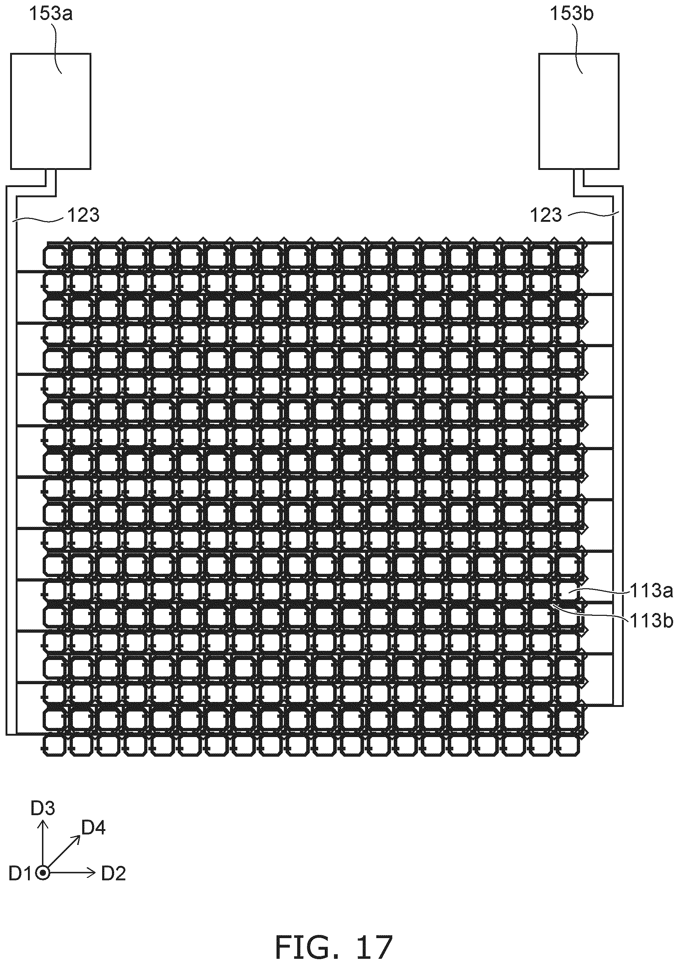

As shown in FIG. 17, openings are formed in the passivation film 124 by RIE, and pads 153a and 153b are exposed. The back surface of the silicon substrate 100a is polished until the thickness of the silicon substrate 100a is 600 µm. A Ti film and a Au film are formed as a back electrode 125. Thereby, the anode electrodes of the avalanche photodiodes are on the pads 153a and 153b side. The cathode electrode is at the back electrode 125 side. The light detector 100 according to the embodiment is manufactured by the processes described above.

The back electrode 125 of the manufacturing processes described above corresponds to the electrode 21 of the light detector 100. The silicon substrate 100a corresponds to the conductive layer 22. A portion of the silicon epitaxial layer 101 and the implantation region 1062 corresponds to the first semiconductor region 1. Another portion of the silicon epitaxial layer 101 corresponds to the fourth semiconductor region 4, the semiconductor region 6, and the semiconductor region 7. The p-type avalanche layer 109 corresponds to the second semiconductor region 2. The n-type avalanche layers 113a and 113b correspond respectively to the third and fifth semiconductor regions 3 and 5. The silicon oxide film 1061 and the buried oxide film 1063 correspond respectively to the insulating layers 30a and 30b. The silicon oxide film 107 corresponds to the insulating layer 41. The insulating film 114 corresponds to the insulating layer 42. The insulating film 118 corresponds to the insulating layer 43. The passivation film 124 corresponds to the insulating layer 44. The quenching resistance 112 corresponds to the first quenching part 51. The titanium film 120, the titanium nitride film 121, and the tungsten film 122 correspond to the plugs. The aluminum layer 123 corresponds to the first interconnect 61, the interconnect 61b, the second interconnect 62, and the interconnect 62b. The pads 153a and 153b correspond respectively to the first and second pads 71 and 72.

Effects of the first embodiment will now be described.

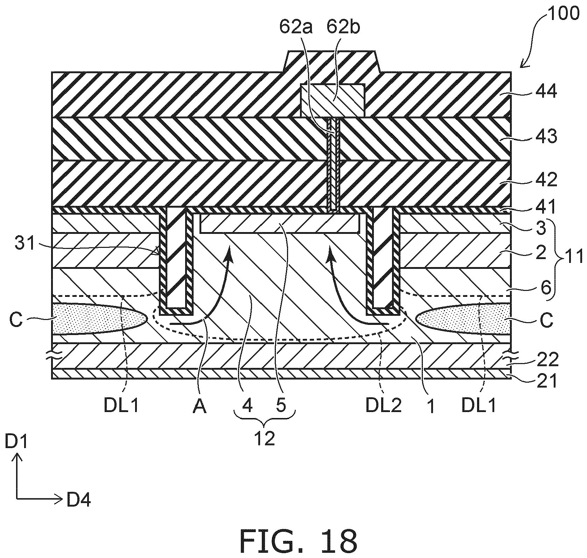

FIG. 18 is a schematic cross-sectional view showing a portion of the light detector according to the first embodiment.

In the first element 11 as shown in FIG. 18, a depletion layer DL1 spreads from the interface between the second semiconductor region 2 and the third semiconductor region 3 when a reverse voltage is applied between the second semiconductor region 2 and the third semiconductor region 3. When light enters the first element 11 when operating in a Geiger mode and photoelectric conversion occurs in the depletion layer DL1, carriers drift through the depletion layer DL1, and avalanche breakdown occurs. A signal flows in the first interconnect 61 and the first pad 71 based on the avalanche breakdown.

It is desirable for the depletion layer DL1 to be separated from the conductive layer 22. This is because if the depletion layer DL1 reaches the conductive layer 22, carriers that exist in the conductive layer 22 diffuse into the depletion layer DL1, avalanche breakdown occurs, and noise is caused. On the other hand, if the depletion layer DL1 is separated from the conductive layer 22, when a large amount of light enters the first element 11 and many carriers C are generated, the carriers C are generated not only in the depletion layer DL1 but also below the depletion layer DL1. The carriers C that are generated below the depletion layer DL1 diffuse through the semiconductor region until disappearing.

The carriers C that diffuse into the depletion layer DL1 drift through the depletion layer DL1 and cause avalanche breakdown to occur. For example, avalanche breakdown continuously occurs if the multiple carriers C progressively drift into the depletion layer DL1. Thereby, a saturation phenomenon called pile up occurs in the first element 11. For example, after the pulse signal based on the initial avalanche breakdown is detected, a long tail accompanies the pulse signal due to the avalanche breakdown that continuously occurs. While the tail exists, a sufficient gain cannot be obtained in the first element 11, and the first element 11 is in a dead state.

For this problem, the light detector 100 further includes the second element 12. In the second element 12, a depletion layer DL2 spreads from the interface between the fourth semiconductor region 4 and the fifth semiconductor region 5 when the reverse voltage is applied between the fourth semiconductor region 4 and the fifth semiconductor region 5. The impurity concentration of the first conductivity type in the fourth semiconductor region 4 is less than the impurity concentration of the first conductivity type in the second semiconductor region 2. Therefore, the depletion layer DL2 of the second element 12 spreads downward more easily than the depletion layer DL1 of the first element 11. For example, in the first element 11, the entire second semiconductor region 2 is depleted, and the depletion layer DL1 spreads to the semiconductor region 6. In the second element 12, the entire fourth semiconductor region 4 is depleted, and the depletion layer DL2 spreads to the first semiconductor region 1.

A lateral electric field is generated in the region below the depletion layer DL1 by the spreading of the depletion layer DL2. The carriers C that accumulate below the depletion layer DL1 are pulled into the depletion layer DL2 by the lateral electric field as shown by arrows A, and the carriers C drift through the depletion layer DL2 and flow toward the fifth semiconductor region 5. Due to the ejection of the carriers C by the second element 12, the time that the carriers C accumulate below the depletion layer DL1 can be reduced even when a large amount of light enters the first element 11. As a result, the time in the dead state of the first element 11 can be reduced.

The signal that is generated by the avalanche breakdown in the first element 11 passes through the first interconnect 61 and is extracted from the first pad 71. The signal that is generated in the second element 12 passes through the second interconnect 62 and is ejected from the second pad 72. For example, by using only the signal extracted from the first pad 71, it is possible to reduce the dead time or increase the measurement precision of the light time-of-flight.

Secondary photons also are generated when the light enters the first element 11. A portion of the secondary photons travels toward the adjacent first elements 11. The refractive index of the insulating body 30 (the first insulating portion 31) is different from the refractive index of the first element 11. Therefore, at least a portion of the secondary photons is reflected by the interface of the insulating body 30. By providing the insulating body 30, the crosstalk noise can be reduced.

Favorably, as shown in FIG. 2, the insulating body 30 includes the multiple first insulating portions 31 that are separated from each other. Compared to when one first insulating portion 31 is provided between the adjacent first elements 11, the number of interfaces of the first insulating portion 31 is increased when multiple first insulating portions 31 that are separated from each other are provided. By increasing the number of interfaces, the secondary photons that travel toward the adjacent first elements 11 are reflected more easily. The crosstalk noise can be further reduced thereby.

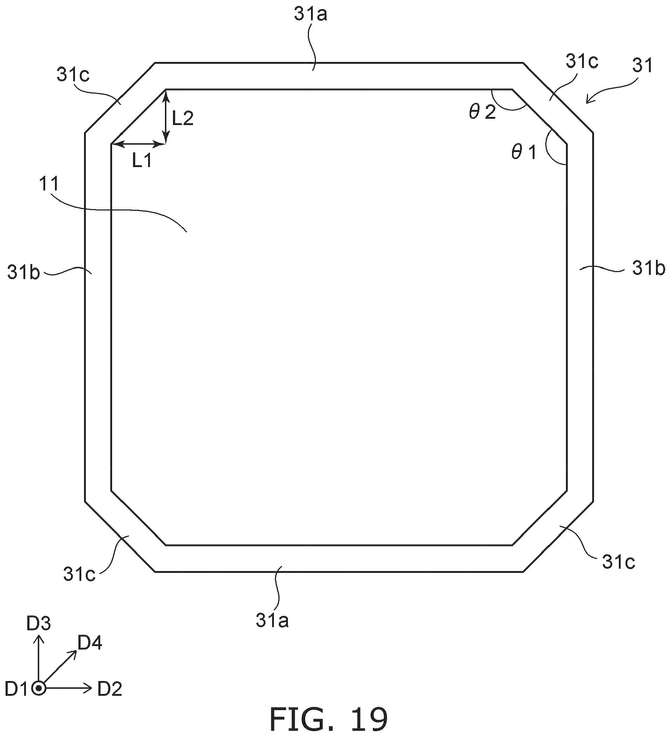

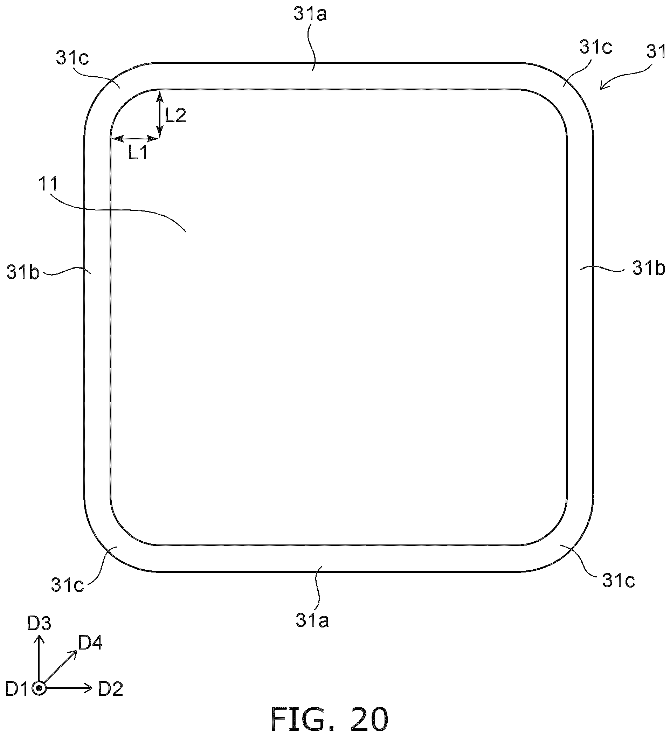

FIGS. 19 and 20 are schematic plan views illustrating a portion of the light detector according to the first embodiment.

For example, the first insulating portion 31 is a five-or-higher-sided polygon when viewed along the first direction D1. In the example shown in FIG. 19, the first insulating portion 31 is an octagon when viewed along the first direction D1. Specifically, the first insulating portion 31 includes a pair of first extension portions 31a extending along the second direction D2, a pair of second extension portions 31b extending along the third direction D3, and multiple link portions 31c. The first element 11 is provided between the pair of first extension portions 31a in the third direction D3. The first element 11 is provided between the pair of second extension portions 31b in the second direction D2. Each link portion 31c links one end of the first extension portion 31a and one end of the second extension portion 31b.

The length in the second direction D2 of the first extension portion 31a is greater than the length in the second direction D2 of the link portion 31c. The length in the third direction D3 of the second extension portion 31b is greater than the length in the third direction D3 of the link portion 31c. For example, the link portion 31c has a straight-line shape when viewed along the first direction D1. It is favorable for an angle θ1 between the first extension portion 31a and the link portion 31c to be 135 degrees or more. It is favorable for an angle θ2 between the second extension portion 31b and the link portion 31c to be 135 degrees or more.

It is favorable for a length L1 in the second direction D2 of the link portion 31c and a length L2 in the third direction D3 of the link portion 31c each to be 1 µm or more.

Or, when viewed along the first direction D1 as shown in FIG. 20, the corners of the first insulating portion 31 may be curved. In other words, the link portions 31c may be curved when viewed along the first direction D1. In the example shown in FIG. 20, the first insulating portion 31 is a rounded rectangle when viewed along the first direction D1. For example, one end of the link portion 31c linked to the first extension portion 31a is along the second direction D2. The other end of the link portion 31c linked to the second extension portion 31b is along the third direction D3. Thereby, the link portion 31c is smoothly linked to the first extension portion 31a and the second extension portion 31b.

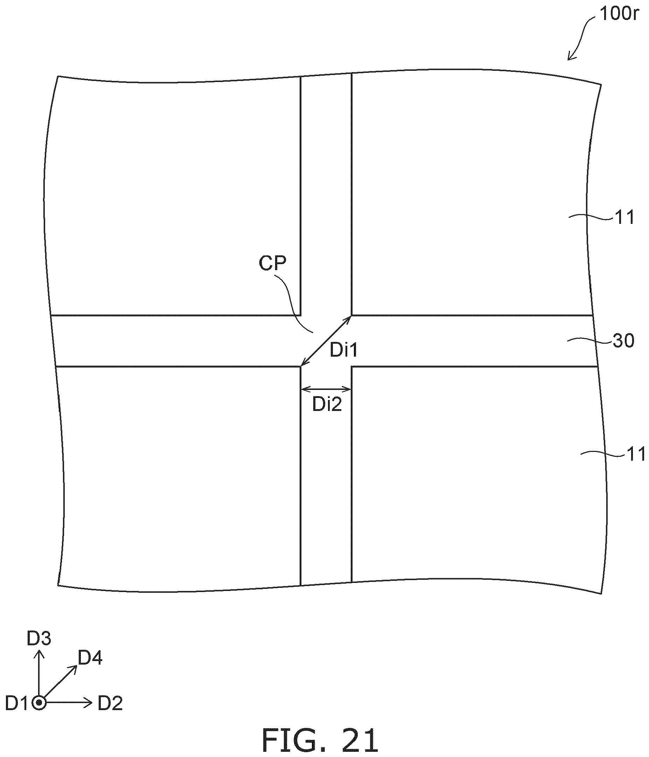

FIG. 21 is a schematic plan view illustrating a portion of a light detector according to a reference example.

In the light detector 100r according to the reference example shown in FIG. 21, the insulating body 30 is provided in a lattice configuration. Specifically, a portion of the insulating body 30 extends along the second direction D2. Another portion of the insulating body 30 extends along the third direction D3. The corners of the first elements 11 are about 90 degrees at a crossing portion CP vicinity between the portion of the insulating body 30 extending along the second direction D2 and the portion of the insulating body 30 extending along the third direction D3. Compared to the other portions, a large stress is generated between the insulating body 30 and the first elements 11 at the crossing portion CP vicinity due to the protrusion of the corners of the first elements 11.

As shown in FIG. 19, when the first insulating portion 31 is a five-or-higher-sided polygon when viewed along the first direction D1, the interior angles of the first insulating portion 31 can be larger. For example, according to the structure shown in FIG. 19, the interior angle between the first extension portion 31a and the link portion 31c and the interior angle between the second extension portion 31b and the link portion 31c can be 135 degrees or more. Or, the corners of the first insulating portion 31 can be curved when the first insulating portion 31 is a rounded polygon when viewed along the first direction D1 as shown in FIG. 20. According to these structures, the stress that is applied between the first element 11 and the first insulating portion 31 at the corners of the first insulating portion 31 can be relaxed. For example, by relaxing the stress, the occurrence of cracks in the first element 11 and the first insulating portion 31 can be suppressed. Operation errors that are caused by the occurrence of cracks can be suppressed.

Also, if cracks occur in the silicon epitaxial layer 101, the silicon oxide film 1061, or the buried oxide film 1063 when forming the silicon oxide film 1061 and the buried oxide film 1063 corresponding to the first insulating portion 31, there is a possibility that a resist in a subsequent photolithography process may enter the cracks. If the resist enters the cracks, a residue of the resist in the cracks occurs when the resist is stripped away. The residue of the resist causes organic contamination of oxidation ovens in subsequent heating processes such as oxidization. By relaxing the stress on the silicon epitaxial layer 101, the silicon oxide film 1061, and the buried oxide film 1063, the occurrence of cracks can be suppressed, and the yield of the light detector 100 can be increased.

In the structure of the insulating body 30 shown in FIG. 21, a dimension Di1 in the fourth direction D4 of the crossing portion CP is about 1.4 times a dimension Di2 in the second direction D2 or the third direction D3 of the crossing portion CP. In other words, at the portion where the crossing portion CP is formed in the process corresponding to FIGS. 8A and 8B when manufacturing the structure shown in FIG. 21, the dimension in the fourth direction D4 of the first trench 106 is about 1.4 times the dimension Di2 in the second direction D2 or the third direction D3. Due to this dimensional difference, when forming the buried oxide film 1063 in the first trench 106, the first trench 106 is not completely filled into the crossing portion CP, and voids occur in the buried oxide film 1063. Similarly to the cracks, the resist enters the voids, and a residue of the resist in the voids occurs. According to the structures shown in FIGS. 19 and 20, the local increase of the dimension of the first trench 106 can be avoided, and the occurrence of voids can be suppressed.

In the example shown in FIGS. 19 and 20, it is favorable for the lengths of the link portion 31c in the X-direction and the Y-direction each to be 1 µm or more. The stress that is generated at the link portion 31c vicinity can be effectively relaxed thereby.

In the example described herein, the first insulating portion 31 includes the pair of first extension portions 31a, the pair of second extension portions 31b, and the multiple link portions 31c. It is sufficient for the first insulating portion 31 to include at least one first extension portion 31a, one second extension portion 31b, and one link portion 31c connected to each other. Thereby, the stress at the vicinity of the region where the one first extension portion 31a, the one second extension portion 31b, and the one link portion 31c are provided can be relaxed.

### Second embodiment

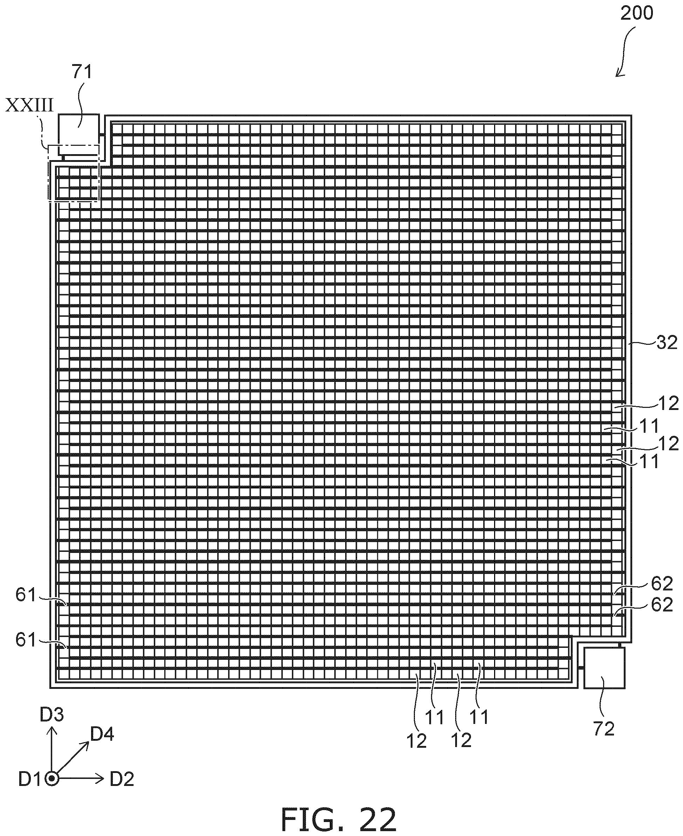

FIG. 22 is a schematic plan view illustrating a light detector according to a second embodiment.

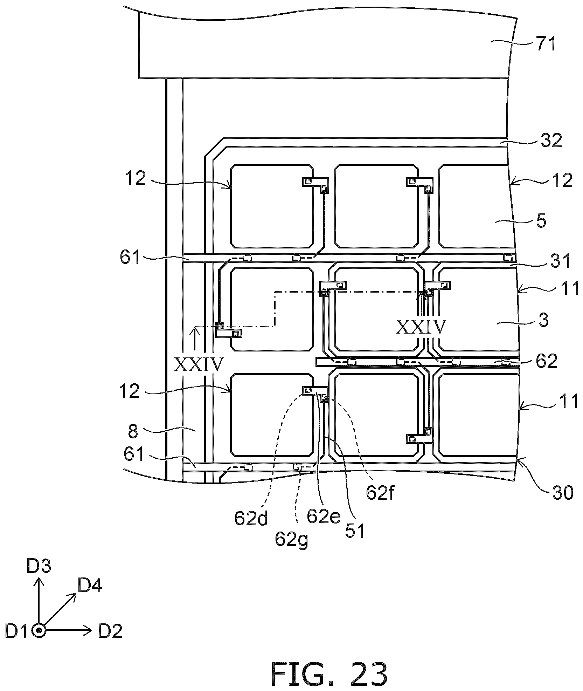

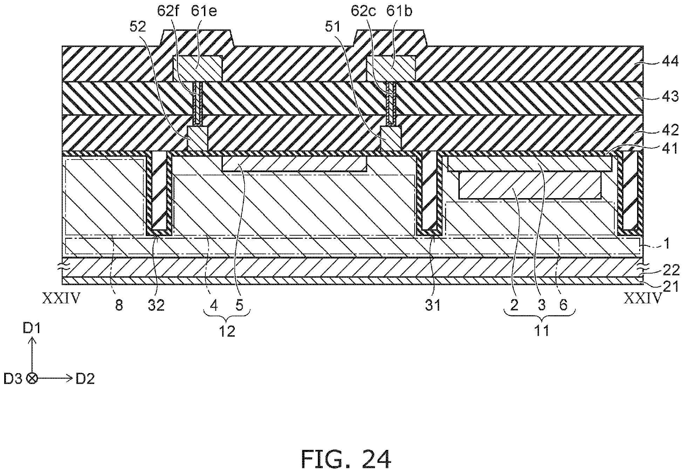

FIG. 23 is an enlarged plan view of portion XXIII of FIG. 22. FIG. 24 is a XXIV-XXIV cross-sectional view of FIG. 23.

In the light detector 200 according to the second embodiment as shown in FIGS. 22 and 23, the multiple second elements 12 are provided around the multiple first elements 11 along the first plane. For example, a column of the multiple first elements 11 that is arranged along the second direction D2 is provided between the pair of second elements 12 in the second direction D2. A column of the multiple first elements 11 that is arranged along the third direction D3 is provided between a pair of second elements 12 in the third direction D3.

As shown in FIG. 23, when viewed along the first direction D1, the shape of the p-n junction surface between the second semiconductor region 2 and the third semiconductor region 3 may be the same as the shape of the p-n junction surface between the fourth semiconductor region 4 and the fifth semiconductor region 5. When viewed along the first direction D1, the surface area of the p-n junction surface between the second semiconductor region 2 and the third semiconductor region 3 may be equal to the surface area of the p-n junction surface between the fourth semiconductor region 4 and the fifth semiconductor region 5.

The fifth semiconductor region 5 is electrically connected to the second interconnect 62. For example, the fifth semiconductor region 5 is electrically connected to the second interconnect 62 via a plug 62d, an interconnect 62e, a plug 62f, a second quenching part 52, and a plug 62g.

The electrical resistance of the second quenching part 52 is greater than the electrical resistances of the plug 62d, the interconnect 62e, the plug 62f, the second quenching part 52, and the plug 62g. It is favorable for the electrical resistance of the second quenching part 52 to be not less than 50 kΩ and not more than 2 MΩ. Materials and structures that are similar to those of the plugs 61a, 61c, and 61d are applicable to the plugs 62d, 62f, and 62g.

As shown in FIGS. 23 and 24, a second insulating portion 32 is provided along the first plane around the multiple second elements 12. Materials and structures that are similar to those of the insulating body 30 are applicable to the second insulating portion 32. The material of the second insulating portion 32 is, for example, the same as the material of the insulating body 30.

A semiconductor region 8 of the first conductivity type may be provided along the first plane around the second insulating portion 32. The semiconductor region 8 includes the same semiconductor material as the first semiconductor region 1. The p-type impurity concentration in the semiconductor region 8 is, for example, not less than 1.0×10¹³ atoms/cm³ and not more than 1.0×10¹⁶ atoms/cm³. The p-type impurity concentration in the semiconductor region 8 may be equal to the p-type impurity concentration in the first semiconductor region 1.

As shown in FIG. 24, a portion of the semiconductor region 8 is arranged with the third and fifth semiconductor regions 3 and 5 in the second direction D2 or the third direction D3. In other words, an n-type semiconductor region is not provided on the semiconductor region 8.

By providing the semiconductor region 8 around the multiple second elements 12, the distance between the multiple second elements 12 and the outer perimeter end portion of the light detector 200 can be increased. Thereby, for example, the likelihood of damage to the second element 12 occurring when dicing the semiconductor substrate in the manufacturing processes of the light detector 200 can be reduced.

It is favorable for the conductivity type of the semiconductor region 8 to be the same conductivity type as the first semiconductor region 1. Thereby, the potential of the semiconductor region 8 can be fixed to the potential of the conductive layer 22 via the first semiconductor region 1. A floating state of the potential of the semiconductor region 8 can be suppressed.

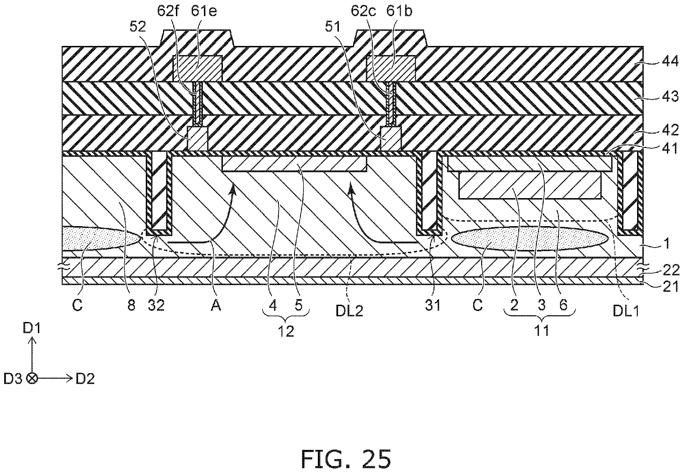

FIG. 25 is a schematic cross-sectional view showing a portion of the light detector according to the second embodiment.

As shown in FIG. 25, similarly to the light detector 100, a reverse voltage is applied to the first and second elements 11 and 12 in the light detector 200. The first element 11 is operable in a Geiger mode. When the reverse voltage is applied to the second element 12, the depletion layer DL2 that spreads from the interface between the fourth semiconductor region 4 and the fifth semiconductor region 5 reaches the first semiconductor region 1. Thereby, the carriers C that accumulate below the depletion layer DL1 are extracted toward the fifth semiconductor region 5 as shown by arrows A. As a result, the time in the dead state of the first element 11 can be reduced.

When light is incident on the first element 11, the light also may be incident on the semiconductor region 8. At this time, the carriers C accumulate also in the semiconductor region 8 due to photoelectric conversion. When the second element 12 is not provided, there is a possibility that the accumulated carriers C may diffuse into the first element 11 and cause a dead state of the first element 11 to occur. By providing the second element 12 between the first element 11 and the semiconductor region 8, the carriers C that are generated in the semiconductor region 8 can be ejected via the second element 12. The occurrence of the dead state of the first element 11 due to the carriers C of the semiconductor region 8 is suppressed thereby.

The configuration of the light detector 200 according to the second embodiment is combinable as appropriate with the configuration of the light detector 100 according to the first embodiment. For example, one second element 12 may be provided between a pair of first elements 11 adjacent to each other in the fourth direction D4; and other multiple second elements 12 may be provided around the multiple first elements 11. For example, the one second element 12 and the multiple second elements 12 may be electrically connected to the same second pad 72 via the multiple second interconnects 62. According to this combination, the time in the dead state can be reduced for more of the first elements 11.

### Third embodiment

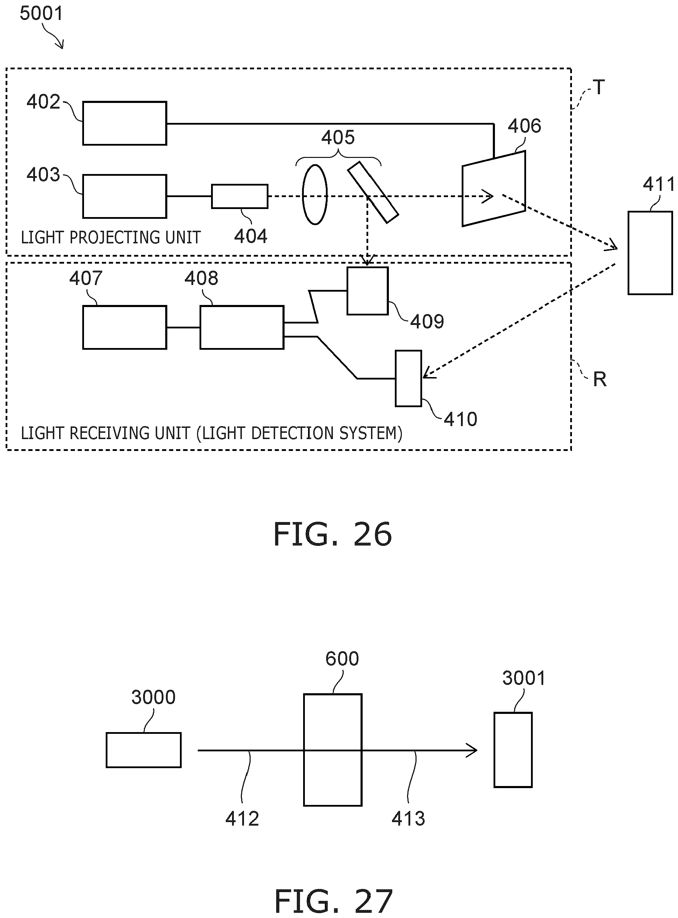

FIG. 26 is a schematic view illustrating a lidar (Laser Imaging Detection and Ranging (LIDAR)) device according to a third embodiment.

The embodiment is applicable to a long-distance subject detection system (LIDAR) or the like including a line light source and a lens. The lidar device 5001 includes a light projecting unit T projecting laser light toward an object 411, and a light receiving unit R (also called a light detection system) receiving the laser light from the object 411, measuring the time of the round trip of the laser light to and from the object 411, and converting the time into a distance.

In the light projecting unit T, a laser light oscillator (also called a light source) 404 produces laser light. A drive circuit 403 drives the laser light oscillator 404. An optical system 405 extracts a portion of the laser light as reference light, and irradiates the rest of the laser light on the object 411 via a mirror 406. A mirror controller 402 projects the laser light onto the object 411 by controlling the mirror 406. Herein, "project" means to cause the light to strike.

In the light receiving unit R, a reference light detector 409 detects the reference light extracted by the optical system 405. A light detector 410 receives the reflected light from the object 411. A distance measuring circuit 408 measures the distance to the object 411 based on the reference light detected by the reference light detector 409 and the reflected light detected by the light detector 410. An image recognition system 407 recognizes the object 411 based on the results measured by the distance measuring circuit 408.

The lidar device 5001 employs ToF in which the time of the round trip of the laser light to and from the object 411 is measured and converted into a distance. The lidar device 5001 is applied to an automotive drive-assist system, remote sensing, etc. Good sensitivity is obtained particularly in the near-infrared region when the light detectors of the embodiments described above are used as the light detector 410. Therefore, the lidar device 5001 is applicable to a light source of a wavelength band invisible to humans. For example, the lidar device 5001 can be used for obstacle detection in a vehicle.

FIG. 27 is a drawing for describing the detection of the detection object of the lidar device.

A light source 3000 emits light 412 toward an object 600 which is the detection object. A light detector 3001 detects light 413 that passes through the object 600, is reflected by the object 600, or is diffused by the object 600.

For example, the light detector 3001 realizes a highly-sensitive detection when the light detector according to the embodiment described above is used. It is favorable to provide multiple sets of the light detector 410 and the light source 404 and to preset the arrangement relationship in the software (which is replaceable with a circuit). For example, it is favorable for the arrangement relationship of the sets of the light detector 410 and the light source 404 to be provided at uniform spacing. Thereby, an accurate three-dimensional image can be generated by the output signals of each light detector 410 complementing each other.

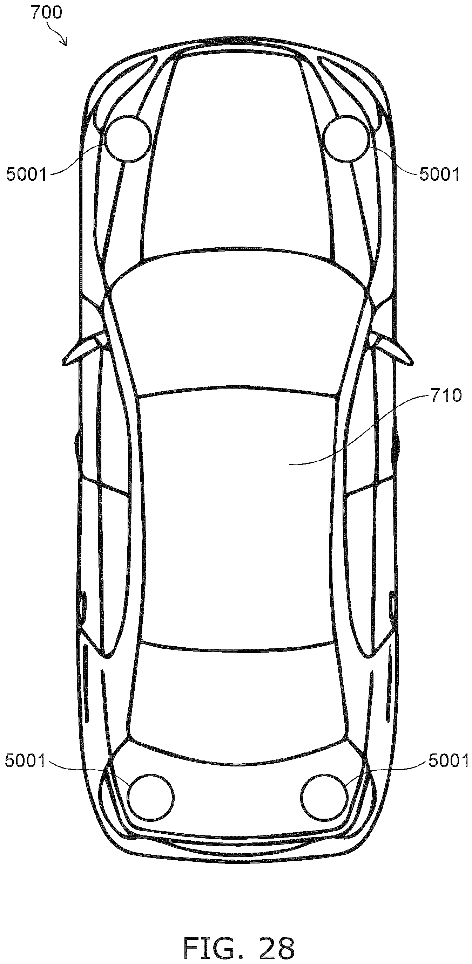

FIG. 28 is a schematic top view of a vehicle including the lidar device according to the third embodiment.

The vehicle 700 according to the embodiment includes the lidar devices 5001 at four corners of a vehicle body 710. Because the vehicle according to the embodiment includes the lidar devices at the four corners of the vehicle body, the environment in all directions of the vehicle can be detected by the lidar devices.

In each of the embodiments described above, the relative levels of the impurity concentrations between the semiconductor regions can be confirmed using, for example, a SCM (scanning capacitance microscope). The carrier concentration in each semiconductor region can be considered to be equal to the activated impurity concentration in each semiconductor region. Accordingly, the relative levels of the carrier concentrations between the semiconductor regions also can be confirmed using SCM. The impurity concentration in each semiconductor region also can be measured by, for example, SIMS (secondary ion mass spectrometry).

According to the embodiments described above, the dead time of the light detector can be reduced.

In the specification of the application, "perpendicular" and "parallel" refer to not only strictly perpendicular and strictly parallel but also include, for example, the fluctuation due to manufacturing processes, etc. It is sufficient to be substantially perpendicular and substantially parallel.

Hereinabove, exemplary embodiments of the invention are described with reference to specific examples. However, the embodiments of the invention are not limited to these specific examples. For example, one skilled in the art may similarly practice the invention by appropriately selecting specific configurations of components included in light detectors such as electrodes, conductive layers, semiconductor regions, insulating bodies, quenching parts, plugs, interconnects, pads, etc., from known art. Such practice is included in the scope of the invention to the extent that similar effects thereto are obtained.

Further, any two or more components of the specific examples may be combined within the extent of technical feasibility and are included in the scope of the invention to the extent that the purport of the invention is included.

Moreover, all light detectors, light detection systems, lidar devices, and vehicles practicable by an appropriate design modification by one skilled in the art based on the light detectors, the light detection systems, the lidar devices, and the vehicles described above as embodiments of the invention also are within the scope of the invention to the extent that the purport of the invention is included.

Various other variations and modifications can be conceived by those skilled in the art within the spirit of the invention, and it is understood that such variations and modifications are also encompassed within the scope of the invention.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

## Claims

1. A light detector (100), comprising:
a first semiconductor region (1) of a first conductivity type;
a first element (11) including
a second semiconductor region (2) provided on the first semiconductor region (1), the second semiconductor region (2) being of the first conductivity type, and
a third semiconductor region (3) provided on the second semiconductor region (2), the third semiconductor region (3) being of a second conductivity type and contacting the second semiconductor region (2);
a second element (12) arranged with the first element (11) in a direction perpendicular to a first direction (D1), the first direction (D1) being from the first semiconductor region (1) toward the first element (11), the second element (12) including
a fourth semiconductor region (4) provided on the first semiconductor region (1), the fourth semiconductor region (4) being of the first conductivity type, an impurity concentration of the first conductivity type in the fourth semiconductor region (4) being less than an impurity concentration of the first conductivity type in the second semiconductor region (2), and
a fifth semiconductor region (5) provided on the fourth semiconductor region (4), the fifth semiconductor region (5) being of the second conductivity type and contacting the fourth semiconductor region (4);
an insulating body (30) provided between the first element (11) and the second element (12);
a first interconnect (61) electrically connected to the third semiconductor region; and
a second interconnect (62) electrically connected to the fifth semiconductor region.

2. The light detector (100) according to claim 1, wherein
the insulating body (30) is provided around the first element (11) along a first plane perpendicular to the first direction (D1).

3. The light detector (100) according to claim 1, wherein
a plurality of the first elements (11) is provided in a second direction (D2) and a third direction (D3),
the second direction (D2) is perpendicular to the first direction (D1),
the third direction (D3) is perpendicular to the first and second directions (D1, D2),
the second element (12) is provided between the first elements (11) in a fourth direction, and
the fourth direction is perpendicular to the first direction (D1) and oblique to the second and third directions (D2, D3).

4. The light detector (100) according to claim 1, wherein
a plurality of the first elements (11) and a plurality of the second elements (12) are provided,
the plurality of first elements (11) is arranged along a second direction (D2) and a third direction (D3),
the second direction (D2) is perpendicular to the first direction (D1),
the third direction (D3) is perpendicular to the first and second directions (D1, D2),
a portion of the plurality of second elements (12) is provided between the first elements (11) in a fourth direction,
the fourth direction is perpendicular to the first direction (D1) and oblique to the second and third directions (D2, D3), and
an other portion of the plurality of second elements (12) is provided around the plurality of first elements (11) along a first plane perpendicular to the first direction (D1).

5. The light detector (100) according to claim 3 or 4, wherein
the insulating body (30) includes a plurality of first insulating portions (31) provided respectively around the plurality of first elements (11) along a first plane perpendicular to the first direction (D1), and
the plurality of first insulating portions (31) is separated from each other.

6. The light detector (100) according to claim 5, wherein
at least a portion of the plurality of first insulating portions (31) includes:
a first extension portion (31a) extending along the second direction (D2);
a second extension portion (31b) extending along the third direction (D3); and
a link portion (31c) linking the first extension portion (31a) and the second extension portion (31b), and
the first element (11) is arranged with the first extension portion (31a) in the third direction (D3) and arranged with the second extension portion (31b) in the second direction (D2).

7. The light detector (100) according to claim 6, wherein
an angle between the first extension portion (31a) and the link portion (31c) and an angle between the second extension portion (31b) and the link portion (31c) are 135 degrees or more for the at least a portion of the plurality of first insulating portions (31).

8. The light detector (100) according to claim 6 or 7, wherein
the at least a portion of the plurality of first insulating portions (31) is octagonal when viewed along the first direction (D1).

9. The light detector (100) according to claim 6, wherein
the link portion (31c) is curved when viewed along the first direction (D1).

10. The light detector (100) according to any one of claims 6 to 9, wherein
a length in the first direction (D1) of the link portion (31c) and a length in the second direction (D2) of the link portion (31c) are 1 µm or more.

11. The light detector (100) according to any one of claims 1 to 10, further comprising:
a first quenching part (51) electrically connected between the third semiconductor region (3) and the first interconnect (61).

12. The light detector (100) according to any one of claims 1 to 11, further comprising:
a first pad (71) electrically connected to the first interconnect (61); and
a second pad (72) electrically connected to the second interconnect (62) and separated from the first pad (71).

13. A light detector (200), comprising:
a first semiconductor region (1) being of a first conductivity type;
a first element (11) including a second semiconductor region (2) provided on the first semiconductor region (1), and a third semiconductor region (3) provided on the second semiconductor region (2), the second semiconductor region (2) being of a first conductivity type, the third semiconductor region (3) being of a second conductivity type and contacting the second semiconductor region (2), a plurality of the first elements (11) being provided in a second direction (D2) and a third direction (D3), the second direction (D2) being perpendicular to a first direction (D1) from the first semiconductor region (1) toward the first element (11), the third direction (D3) being perpendicular to the first and second directions (D1, D2);
a second element (12) including a fourth semiconductor region (4) and a fifth semiconductor region (5), the fourth semiconductor region (4) being provided on the first semiconductor region (1), being of the first conductivity type, and having a lower first-conductivity-type impurity concentration than the second semiconductor region (2), the fifth semiconductor region (5) being provided on the fourth semiconductor region (4), being of the second conductivity type, and contacting the fourth semiconductor region (4), a plurality of the second elements (12) being provided around the plurality of first elements (11) along a first plane perpendicular to the first direction (D1);
an insulating body (30) provided between the first elements (11) and between the first element (11) and the second element (12);
a first interconnect (61) electrically connected to at least a portion of a plurality of the third semiconductor regions (3); and
a second interconnect (62) electrically connected to at least a portion of a plurality of the fifth semiconductor regions (5).

14. The light detector (100, 200) according to any one of claims 1 to 13, wherein
the first element (11) includes an avalanche photodiode operating in a Geiger mode.

15. A light detection system (R), comprising:
the light detector (410) according to any one of claims 1 to 14; and
a distance measuring circuit (408) calculating a time-of-flight of light from an output signal of the light detector (410).

16. A lidar device (5001), comprising:
a light source (404) irradiating light on an object (410); and
the light detection system (R) according to claim 15 detecting light (410) reflected by the object (410).

17. The lidar device (5001) according to claim 16, further comprising:
an image recognition system (407) generating a three-dimensional image based on an arrangement relationship of the light source (404) and the light detector (410).

18. A vehicle (700), comprising:
the lidar device (5001) according to claim 16 or 17.

19. A vehicle (700), comprising:
the lidar device (5001) according to claim 16 or 17 at each of four corners of a vehicle body (710).
